# EUROPEAN PATENT SPECIFICATION

(11) **EP 4 677 377 B1**
(45) Date of publication and mention of the grant of the patent: **18.02.2026**
(21) Application number: 25710722.7
(22) Date of filing: 28.01.2025
(51) Int. Cl.: G01R 31/40, G01R 31/34

(54) **METHOD OF FAULT DETECTION OF A ROTARY RECTIFIER OF BRUSHLESS SYNCHRONOUS MACHINES WITH INDUCTION MOTOR TYPE EXCITERS**
VERFAHREN ZUR FEHLERERKENNUNG EINES ROTIERENDEN GLEICHRICHTERS VON BÜRSTENLOSEN SYNCHRONMASCHINEN MIT ERREGERN DES INDUKTIONSMOTORTYPS
PROCÉDÉ DE DÉTECTION DE DÉFAUT D'UN REDRESSEUR ROTATIF DE MACHINES SYNCHRONES SANS BALAIS AYANT DES EXCITATEURS DE TYPE MOTEUR À INDUCTION

(30) Priority: 31.01.2024 CZ 20240037
(43) Date of publication of application: 14.01.2026
(73) Proprietor: Západoceská univerzita v Plzni, 301 00 Plzen (CZ)
(72) Inventor: PEROUTKA, Zdenek, 31200 Plzen (CZ); CIBULKA, Jiri, 30100 Plzen (CZ)
(74) Representative: Zmeskal, Lukas
(86) International application number: PCT/CZ2025/050010
(87) International publication number: WO 2025/162514

(56) References cited:
- JP-A- 2008 295 252
- JP-A- 2023 163 979
- JP-A- H11 215 899

## Description

### Field of the invention

The present invention relates to the detection and also determination of a fault type of power electronics devices of a rotary rectifier of brushless synchronous machines, in particular those acting as a reactive power compensator in a power grid. The proposed solution is designed for brushless synchronous machines provided with induction motor type exciters. This type of rotary exciter has been used for the synchronous machine-based compensators almost exclusively, as it is necessary to start them up to excite the machine even at zero speed, which is impossible based on the principle of the rotary exciters of the inverse synchronous type.

### Background of the invention

A common method of a fault diagnosis of stationary rectifiers based on continuous evaluation of the voltage drop across individual power electronics devices, or the published fault detection method based on measurement and comparison of mean or rms value of individual phase currents on the AC side of the stationary rectifiers (refer to e.g., N. M. A. Freire, J. O. Estima and A. J. Marques Cardoso, "Open-Circuit Fault Diagnosis in PMSG Drives for Wind Turbine Applications, " in IEEE Transactions on Industrial Electronics, vol. 60, no. 9, pp. 3957-3967, Sept. 2013, doi: 10.11091TIE.2012.2207655*)* are not, from the design point of view, applicable to the rotary rectifiers placed on the rotors of the brushless synchronous machines. The pulse number of a diagnosed rectifier is used for some known rectifier fault diagnosis methods. The pulse number is defined as a ratio of the frequency of the first harmonic of AC part of the rectified voltage to the frequency of the first harmonic of the voltage on the AC side of the rectifier.

Unless the faults of the power electronics devices of the rotary rectifiers in the brushless synchronous compensators are reliably detected, rotary exciters are current-overloaded under their operation, and thereby enormously heated. This results in faster aging of the exciter insulation and can cause significant financial damage.

Technical solutions detecting the excitation system fault based on the measurement of the leakage magnetic field of the brushless synchronous machines are disclosed, e.g., in ES2738649A1 and ES2738649B2. However, this method requires the installation of special sensors to measure the leakage magnetic field, which is not always an option and costs a lot of money.

JP2008295252 describes a fault detection and protection device for brushless synchronous machines, focusing on the DC excitation current supplied to the rotor via a rotary rectifier. The device analyses the DC component of the exciter field current and detects abnormal increases in superimposed AC components, which indicate failures of the rectifier's semiconductor elements. By digitally sampling this current, the system can distinguish between phase short-circuit and phase-open conditions. If a severe fault is confirmed, a stop command is issued; in less critical cases, constant DC excitation control prevents overexcitation without immediate shutdown. This method allows reliable monitoring of the DC excitation system without additional detection coils, ensuring simpler and more effective machine protection.

JP2023163979 describes a protection device for brushless synchronous machines that supply direct current (DC) excitation through a rotary rectifier containing semiconductor elements. Conventional detection devices often shut down the machine unnecessarily because they cannot distinguish between an actual DC rectifier fault and a malfunction of the detection system. The proposed device uses an unnecessary operation prevention circuit that monitors DC excitation current feedback together with active and reactive power values over time, verifying whether a reported rectifier fault is genuine. Depending on the control method (constant DC excitation or power factor control), it calculates differences in DC current or power and only issues a stop command when thresholds confirm a true semiconductor element failure. This ensures reliable protection of the DC excitation system, avoids unnecessary stoppages, and allows for planned maintenance instead of emergency shutdowns.

JPH11215899 describes an automatic fault detection device for the semiconductor rectifying elements of a rotary rectifier in a brushless exciter of a synchronous motor or generator. The exciter generates AC voltage, which is converted into direct current (DC) excitation for the generator field winding; a fault in a rectifier element can disturb this DC supply. The proposed device uses quick-acting fuses with alarm contacts, connected in series with the rectifier and the DC excitation path, combined with semiconductor light-emitting and light-receiving elements. This arrangement allows detection of which rectifier element has failed while the machine is still operating, by transmitting an optical signal to the stator side and processing it in a logic/display circuit. The system ensures reliable early detection of DC excitation faults with a simple, economical, and compact structure, minimizing downtime.

The invention described below allows reliable detection of faults in the power electronics devices of rotary rectifiers of brushless synchronous machines with an induction motor type exciter without the need to install additional special sensors and other measuring instruments. The invention uses only the measurement instrumentation that has already been commonly included in the machines for their operation.

### Summary of the invention

The present invention relates to a method of detecting faults in rotary rectifiers of brushless synchronous machines with induction motor type exciters according to claim 1. The proper function of the proposed diagnostic algorithm requires that a brushless synchronous machine is designed so that the rotary rectifier operates in the continuous current mode under fault-free conditions of the machine. Another precondition is that a rotation direction of a space vector of the first harmonic of the voltage supplying a device with a rotary magnetic coupling is opposite to the rotation of a space vector of the power grid voltage to which the brushless synchronous machine is connected. Another precondition is that the frequency of the first harmonic of the voltage supplying the device with a rotary magnetic coupling is the same as the frequency of the voltage of the power grid to which the brushless synchronous machine is connected. For a diagnosed rotary rectifier, a fault refers to a situation where a short circuit or open circuit occurs in the place of a faulty power electronics device. The detection method is based on the determination of the content of higher harmonics in the frequency spectrum of one of the measured phase currents, which flows through the device with the rotary magnetic coupling.

The frequency analysis of the measured phase field current flowing through the device with rotary magnetic coupling provides the amplitude of its fundamental harmonic component having the same frequency as the power grid to which the brushless synchronous machine is connected. In addition, an amplitude of all non-zero integer multiples of the fundamental harmonic component is obtained up to the sum of the power grid frequency and the value resulting from the product of the frequency of AC power supply voltage of the diagnosed rotary rectifier and its pulse number *p*. The obtained values of the frequency spectrum amplitudes of the measured phase field current entering the device with the rotary magnetic coupling are used to calculate per-unit fault factor *Xᵢ* by a fraction.

The numerator is a sum of values of the amplitudes of determined frequency components of the measured phase field current of the excitation source having frequencies higher than the fundamental harmonic component, however, with the exclusion of two frequency components. The frequency of the first excluded frequency component equals to the product of the frequency of AC power supply voltage of the diagnosed rotary rectifier and its pulse number p, being increased by the value of the frequency of the power grid to which the brushless synchronous machine is connected. The frequency of the second excluded frequency component equals to the product of the frequency of AC power supply voltage of the diagnosed rotary rectifier and its pulse number p, being decreased by the value of the frequency of the power grid to which the brushless synchronous machine is connected.

The denominator is a sum of values of amplitudes of said two excluded frequency components of the phase field current entering a stator of the device with the rotary magnetic coupling.

A fault-free reference per-unit factor *X_{i_ref}* is calculated under the fault-free conditions. Then, electric disconnection of at least one power electronics device of the rotary rectifier is made to determine the fault reference per-unit factor *X_{i_err}.* The arithmetic mean of values of the fault-free reference per-unit factor *X_{i_ref}* and fault reference per-unit factor *X_{i_err}* is used to calculate the per-unit fault detection threshold *X_{i_threshold}.*

Then, the per-unit fault factor *Xᵢ* is continuously calculated during the operation of the rotary rectifier. The next step determines the distance of the current value of the per-unit fault factor *Xᵢ* from the fault-free condition represented by the fault-free reference per-unit factor *X_{i_ref}.*

To reliably detect threshold fault states of the rotary rectifier, the terminal voltage of the synchronous machine is additionally measured. For the diagnosed rotary rectifier, i.e. the source of excitation, the threshold fault state is a case where a permanent short-circuit occurs on its output DC terminals, or when at least one of the DC poles is permanently disconnected from the field excitation winding of the synchronous machine that forms the brushless synchronous machine together with the rotary exciter and the rotary rectifier. Permanent disconnection of one of the DC poles of the rotary rectifier occurs when permanent circuit disconnection occurs for all power electronics devices belonging to either the cathode or anode group.

The excitation source fault is signalled in case at least one of the following situations occurs after the synchronous machine field excitation procedure is completed which is indicated by the excitation procedure completion signal:
- the per-unit fault factor *X* is higher than the per-unit fault detection threshold *X_{i_threshold}* for time longer than one period of the fundamental harmonic frequency;
- the rms value of the measured phase field current is outside the permitted operation range;
- the rms value of the synchronous machine back EMF is at a phase field current, of which value is within the permissible operating range defined for the synchronous machine, less than the rms value of the synchronous machine back EMF determined for the minimum permissible operating phase field current, wherein the back EMF of the synchronous machine is determined from the measured terminal voltage.

A determination of the power electronics devices that failed at the rotary rectifier requires knowledge of the electric angle of the rotary rectifier. Said angle may be derived from a mathematical model of the induction machine that describes behaviour of the device with the rotary magnetic coupling. To determine the electric angle of the rotary rectifier, it is possible to use either the voltage or current model of the induction machine, the input of which is the space vector of the AC power supply voltage, the space vector of the field current calculated from the measured phase field currents, position or rotational speed of the synchronous machine rotor, and parameters of the equivalent circuit of a device with the rotary magnetic coupling. The space vector of the rotor voltage is calculated as a sum of a derivative of the space vector of the rotor flux of the device with the rotary magnetic coupling and the voltage drop across a rotor resistor. The voltage drop across the rotor resistor may usually be neglected. The equation for the determination of the rotor voltage must be calculated in a rotor reference frame. The electric angle of the rotary rectifier then equals to the position of the calculated vector of the rotor voltage in the rotor reference frame.

**In** a simplified way, the electric angle of the rotary rectifier may be determined using the rotor position of the device with the rotary magnetic coupling and the position of the space vector of the AC power supply voltage in a stationary reference frame. Here, the algorithm assumes that the rotor of the device with the rotary magnetic coupling rotates in the opposite direction to the space vector of the AC power supply voltage.

**In** all of the above calculations, the space vectors of quantities are typically determined via the Clark transformation. The determination of the electrical angle of the rotary rectifier can be performed continuously throughout the operation or once after a fault is detected. Based on the electrical angle of the rotary rectifier to be diagnosed, the power electronics device conduction angle may be determined upon which anomaly shape in the waveform of the measured phase field current entering the device with the rotary magnetic coupling occurs.

The excitation sources, components of which are the rotary rectifiers, which may be diagnosed based on the proposed per-unit fault factor *Xᵢ*, usually but not exclusively, have the configuration as follows:
The excitation source includes the rotary rectifier with the DC terminals, which are electrically connected to the field (excitation) winding of the synchronous machine. The AC terminals of the rotary rectifier are connected to the device with the rotary magnetic coupling (usually an induction motor type exciter located on a common shaft with the synchronous machine). The device with the rotary magnetic coupling is supplied from a three-phase AC source with variable amplitude of the first harmonic component of the terminal voltage (usually, it is either a three-phase indirect frequency converter with a voltage-source inverter or a three-phase AC/AC converter). The frequency of the first harmonic of the voltage supplying the device with a rotary magnetic coupling equals the frequency of the voltage of the power grid to which the brushless synchronous machine is connected. A sequence of phases of the three-phase source with variable amplitude of the first harmonic component, which supplies the device with the rotary magnetic coupling, is, however, opposite to the voltage of the power grid to which the brushless synchronous machine is connected.

The described method may be used to detect the fault of one or more power electronics devices of the rotary rectifier being diagnosed. The type of fault is determined based on the rms value of the back EMF of the main synchronous machine and by comparison of the per-unit fault factor *Xᵢ* with pre-calculated or experimentally determined values for individual types of faults stored in a control computer.

The described invention overcomes the existing solutions for protecting the rotary rectifiers operating in continuous current mode in the brushless synchronous machines with the induction motor type exciter by reliably detecting a fault and determining its type. The proposed solution uses only common HW equipment of control computers (typically excitation controllers). It requires no additional instrumentation and is very simple and robust in terms of its commissioning. The tuning consists of setting only one parameter, which is the per-unit fault detection threshold *X_{i_threshold}.*

### Explanation of drawings

The exemplary embodiment of the proposed solution aimed at diagnosing faults of the power electronics devices of the rotary rectifiers, that operate under continuous current mode in the brushless synchronous machine-based compensators having an induction motor type exciter, has been described with reference to the drawings, in which:

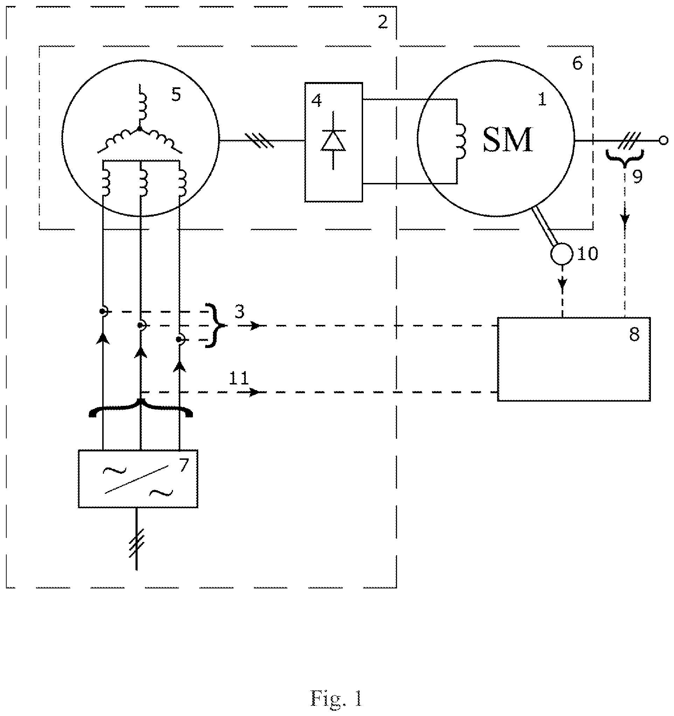

Fig. 1 - is a connection configuration of the synchronous machine with the excitation source comprising a device with a rotary magnetic coupling with a rotary rectifier connected to its output; a device with the rotary magnetic coupling is supplied from a three-phase AC source with variable amplitude of the first harmonic component of the terminal voltage which is usually implemented either by a three-phase indirect frequency converter with a voltage-source inverter or by a three-phase AC/AC converter;

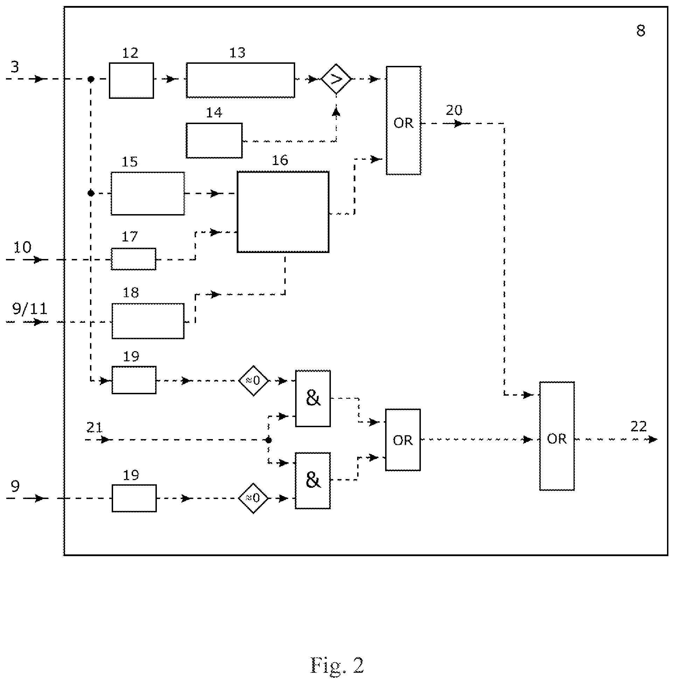

Fig. 2 - is a block scheme describing an algorithm to detect faults of the power electronics devices of the rotary rectifiers operated under continuous current mode in the brushless synchronous machines having an induction motor type exciter.

### Exemplary embodiment of the invention

The exemplary embodiment in Fig. 1 describes the application in which the rotary rectifier 4 usually operates under the continuous current mode, i.e., an essential condition for diagnosing faults of its power electronics devices by the method specified in the present invention is met. It describes a configuration of a field excitation circuit of brushless synchronous machines 6 with induction motor type exciters. An integral part of an excitation source 2 of a synchronous machine 1 is a rotary rectifier 4. The brushless synchronous machine 6 comprises an assembly that includes device 5 with a rotary magnetic coupling (usually an induction motor type exciter located on a common shaft with the synchronous machine 1), the rotary rectifier 4, and the synchronous machine 1. Device 5 with the rotary magnetic coupling is supplied from a three-phase AC excitation source 7 with variable amplitude of the first harmonic component of the terminal voltage (it is usually either a three-phase indirect frequency converter with a voltage-source inverter or a three-phase AC/AC converter). The frequency of the first harmonic component of the AC power supply voltage 11 of device 5 with a rotary magnetic coupling equals to the frequency of the voltage of the power grid to which the brushless synchronous machine 6 is connected. A sequence of phases of the three-phase AC excitation source 7 with variable amplitude of the first harmonic component, which supplies device 5 with the rotary magnetic coupling, is, however, opposite to the voltage of the power grid to which the brushless synchronous machine 6 is connected.

The principle of fault detection of the rotary rectifiers 4 is based, for the brushless synchronous machines 6 with the induction motor type exciter, on a frequency (Fourier) analysis of one of the measured phase field currents 3 flowing through the device 5 with the rotary magnetic coupling. A calculation block 12 provides amplitudes from the frequency analysis of all non-zero integer multiples of the fundamental harmonic frequency up to the harmonic component, which equals to the sum of the power grid frequency and the value resulting from the product of the frequency of AC power supply voltage of the rotary rectifier 4 and its pulse number *4*. The fundamental harmonic frequency equals to the frequency of the power grid to which the brushless synchronous machine 6 is connected. Said frequency is also the same as the frequency of the first harmonic component of the AC power supply voltage 11 of the device 5 with the rotary magnetic coupling. Fault diagnosis of the power electronics devices of the rotary rectifier 4 is conducted by a per-unit fault factor *Xᵢ* calculated in the fault factor calculation block 13. If continuously evaluated per-unit fault factor *Xᵢ* exceeds the defined per-unit fault detection threshold *X_{i_threshold}* (refer to block 14) for a time longer than one period of the fundamental harmonic frequency, signal 20 indicates a fault of the rotary rectifier 4. Insofar as the reason for the excitation source 2 faults may be the rotary rectifier 4 or the threshold fault state, the resulting signal 22 of the excitation source 2 fault is determined by a logical sum of the rotary rectifier 4 fault signal 20 and the output from the logic intended for detection of the threshold fault state in which enters the excitation procedure completion signal 21, refer to Fig. 2.

The logic provides fault detection for the configuration in Fig. 1 in the course of normal operation of the brushless synchronous machine 6 (i.e., the synchronous machine 1 excitation procedure completed, which is indicated by the completion signal 21) and also in case the rms value of the back EMF of the synchronous machine 1 at the phase field current 3, of which rms value is in the permitted operation range defined for said brushless synchronous machine 6, is lower than the rms value of the back EMF of the synchronous machine 1 dedicated for minimum permitted operation rms value of the phase field current 3. To determine the said back EMF of the synchronous machine 1, the measured stator terminal voltage 9 is used. The excitation procedure refers to a state in which the synchronous machine 1 achieved the operating speed and the required rms value of the phase field current 3 increases from 0 to the required value derived from the power grid voltage.

Tuning of the proposed method consists of setting the per-unit fault detection threshold *X_{i_threshold}*; refer to block 14. Tuning is conducted so that the per-unit fault factor *Xᵢ* is calculated in fault-free machine condition to determine the fault-free reference per-unit factor *X_{i_ref}.*

Furthermore, the per-unit fault factor *Xᵢ* is calculated under artificial fault where one power electronics device is not conducting in the rotary rectifier 4. The fault reference per-unit factor *X_{i_err}* is determined thereby. The arithmetic mean of values of the fault-free reference per-unit factor *X_{i_ref}* and fault reference per-unit factor *X_{i_err}* is used to calculate the per-unit fault detection threshold *X_{i_threshold}* (refer to block 14).

The proposed method can also determine a type of fault by short-circuit or by opening one or more power electronics devices of the rotary rectifier 4. The type of fault is determined from rms value 19 of the terminal voltage 9 of the synchronous machine 1 and from comparison of the per-unit fault factor *Xᵢ* (from the fault factor calculation block 13) with pre-calculated or experimentally determined values for each type of fault of the rotary rectifier 4 being stored in a control computer 8 (usually in an excitation controller). The block scheme in Fig. 2 illustrates the algorithm for fault detection of the power electronics devices of the rotary rectifier 4 and of the excitation source 2. Phase field current 3 is the fundamental diagnostic signal described above.

The determination of the power electronics devices that failed at the rotary rectifier 4 requires the knowledge of the electric angle of the rotary rectifier. Said angle may be derived from a mathematical model of the induction machine that describes the behaviour of the device 5 with the rotary magnetic coupling. To determine the electric angle of the rotary rectifier 4, it is possible to use either voltage or current model of the induction machine, the input of which is the space vector of the AC power supply voltage 11, the space vector of the field current calculated from the measured phase field currents 3, position or rotational speed of the synchronous machine 1 rotor multiplied by the number of pole pairs 17 of the device 5 with the rotary magnetic coupling, and parameters of the equivalent circuit of the device 5 with the rotary magnetic coupling. The space vector of the rotor voltage is calculated as a sum of a derivative of the space vector of the rotor flux of device 5 with the rotary magnetic coupling and the voltage drop across a rotor resistor. The drop across the rotor resistor may usually be neglected. The equation for the determination of the rotor voltage must be calculated in a rotor reference frame. The electric angle of the rotary rectifier 4 then equals to the position of the calculated vector of the rotor voltage in the rotor reference frame.

In a simplified way, the electric angle of the rotary rectifier 4 may be determined using the rotor position of device 5 with the rotary magnetic coupling and the position of the space vector of the AC power supply voltage 11 in a stationary reference frame. The algorithm assumes that the rotor of device 5 with the rotary magnetic coupling rotates in the opposite direction than the space vector of the AC power supply voltage 11. The rotor position of device 5 with the rotary magnetic coupling can be obtained, for example, from information about the angular displacement 10 of the synchronous machine 1 rotor from a mechanical sensor.

**In** all of the above calculations, the space vectors of quantities are typically determined via the Clark transformation 18. The evaluation of the electrical angle of the rotary rectifier 4 can be performed continuously throughout the operation or once after a fault is detected. Based on the electrical angle of the rotary rectifier 4 to be diagnosed, the device conduction angle (refer to block 16) may be determined upon which anomaly shape (refer to block 15) in the waveform of the measured phase field current 3 entering the device 5 with the rotary magnetic coupling occurs.

### List of reference numerals

1 synchronous machine
2 excitation source
3 phase field (excitation) current measured at the output of the AC excitation source 7, i.e., phase currents that flow through the stator of the device 5 with the rotary magnetic coupling
4 rotary rectifier
5 device with rotary magnetic coupling (usually an induction motor type exciter located on a common shaft with the synchronous machine 1)
6 brushless synchronous machine with an induction motor type exciter
7 AC excitation source with variable amplitude of the first harmonic component of the terminal voltage (it is typically either a three-phase indirect frequency converter with a voltage-source inverter or a three-phase AC/AC converter) that powers the device 5 with the rotary magnetic coupling
8 control computer, typically a field excitation controller in which algorithms for diagnosing faults of the rotary rectifier 4 are implemented
9 terminal voltage of the synchronous machine 1
10 synchronous machine 1 angular rotor position determined from a mechanical sensor
11 AC power supply voltage of device 5 with the rotary magnetic coupling
12 block for calculation of amplitude of the fundamental harmonic component (FFT), having the same frequency as the power grid to which the brushless synchronous machine 6 is connected, and amplitudes of all non-zero integer multiples of the fundamental harmonic frequency up to the harmonic component, which frequency equals to the sum of the power grid frequency and the value resulting from the product of the frequency of AC power supply voltage of the diagnosed rotary rectifier 4 and its pulse number*p*
13 block for calculation of per-unit fault factor *Xᵢ* calculated by a quotient, where the numerator is a sum of values of the amplitudes of the determined frequency components of the measured phase field current 3 of the excitation source 2 having frequencies higher than the fundamental harmonic component, however, with the exclusion of two frequency components. The frequency of the first excluded frequency component equals to the product of the frequency of AC power supply voltage of the diagnosed rotary rectifier 4 and its pulse number *p*, being increased by the frequency of the power grid to which the brushless synchronous machine 6 is connected. The frequency of the second excluded frequency component equals to the product of the frequency of AC power supply voltage of the diagnosed rotary rectifier 4 and its pulse number *p*, being decreased by the frequency of the power grid to which the brushless synchronous machine 6 is connected. The denominator is a sum of amplitudes of said two excluded frequency components of the phase field current 3 entering a stator of the device 5 with the rotary magnetic coupling
14 per-unit fault detection threshold *X_{i_threshold}* calculated as an arithmetic mean of the fault-free reference per-unit factor *X_{i_ref}* calculated in the fault-free state of the diagnosed rotary rectifier 4 and fault reference per-unit factor *X_{i_err}* under artificial fault where one power electronics device is not conducting in the rotary rectifier 4
15 block detecting an anomaly in the waveform of measured phase field current 3 flowing through the stator of the device 5 with the rotary magnetic coupling
16 block determining a cycle in which a faulty power electronics device of the rotary rectifier 4 would be active in case of fault-free condition, based on the determined electric angle value of the diagnosed rotary rectifier 4, at which there is anomaly deformation in the waveform of the measured phase field current 3 entering to the stator of the device 5 with the rotary magnetic coupling
17 number of pole pairs *pp* of the device 5 with the rotary magnetic coupling
18 space vector transformation (usually using the Clark transformation)
19 calculation of rms value from the waveform of the measured quantity
20 rotary rectifier 4 fault signal
21 excitation procedure completion signal, synchronous machine 1 operation mode
22 excitation source 2 fault signal

## Claims

1. A method of fault detection of a rotary rectifier (4) of brushless synchronous machines (6) with induction motor type exciters, wherein the rotary rectifier (4) connects the field excitation winding on the rotor of a synchronous machine (1) with a device (5) with a rotary magnetic coupling being connected to AC excitation source (7), **characterized in that** a phase field current (3) is measured at the output side of the AC excitation source (7) which is connected to the device (5) with the rotary magnetic coupling, further, a frequency analysis (12) of the measured field current (3) determines
the amplitude of its fundamental harmonic having the same frequency as the power grid to which the brushless synchronous machine (6) is connected, and
amplitudes of all non-zero integer multiples of the fundamental harmonic frequency up to the sum of the power grid frequency and the value resulting from the product of the frequency of AC power supply voltage of the diagnosed rotary rectifier (4) and its pulse number*p*,
further, the quotient is used to calculate the per-unit fault factor *Xᵢ*, where
the numerator is a sum of values of amplitudes of determined frequency components of the measured phase field current (3) of the excitation source (2) having frequencies higher than the fundamental harmonic component, however, with the exclusion of two frequency components having frequencies defined so that
the frequency of the first excluded frequency component equals to the product of the frequency of AC power supply voltage of the diagnosed rotary rectifier (4) and its pulse number p, being increased by the frequency of the power grid to which the brushless synchronous machine (6) is connected, and
the frequency of the second excluded frequency component equals to the product of the frequency of AC power supply voltage of the diagnosed rotary rectifier (4) and its pulse number *p*, being decreased by the frequency of the power grid to which the brushless synchronous machine (6) is connected,
and the denominator is a sum of values of amplitudes from said two excluded frequency components of the phase field current (3) entering a stator of the device (5) with the rotary magnetic coupling,
under a fault-free condition, a fault-free reference per-unit factor *X_{i_ref}* is calculated, followed by electric disconnection of at least one power electronics device of the rotary rectifier (4), and the fault reference per-unit factor *X_{i_err}* is determined,
the arithmetic mean of values of the fault-free reference per-unit factor *X_{i_ref}* and fault reference per-unit factor *X_{i_err}* is used to calculate per-unit fault detection threshold *X_{i_threshold}*,
and during the operation of the rotary rectifier (4), the per-unit fault factor *Xᵢ* is continuously calculated, and with the excitation procedure of the synchronous machine (1) completed, which is indicated by signal (21), the excitation source (2) fault is signalized in case that
- the per-unit fault factor *Xᵢ* is higher than the per-unit fault detection threshold *X_{i_threshold}* for a time longer than one period of the fundamental harmonic frequency; and/or
- rms value of the measured phase field current (3) is outside the permitted operation range; and/or
- rms value of the synchronous machine (1) back EMF is at the phase field current (3), which value is within the permissible operating range defined for the synchronous machine (1), less than the rms value of the synchronous machine (1) back EMF determined for the minimum permissible operating phase field current (3), wherein the back EMF of the synchronous machine (1) is determined from the measured terminal voltage (9).

2. The method according to claim 1 **characterized in that** in addition, excitation source (2) fault type caused by short-circuit or opening of one or more power electronics devices of the rotary rectifier (4) is determined, when the size of rms value of the phase field current (3) and the rms value of the back EMF of the synchronous machine (1) is in permitted operating range, by comparison of continuously determined per-unit fault factor *Xᵢ* with the values calculated in advance or determined in experiments, which are stored in a control computer (8) for each type of fault of the rotary rectifier (4).

3. The method according to claim 1 or 2 **characterized in that** at least one harmonic frequency is omitted in the calculation (13) of the per-unit fault factor *Xᵢ* in the sum in the numerator.

4. The method according to any of the previous claims 1 to 3 **characterized in that** inputs of a dynamic mathematical model of the device (5) with the rotary magnetic coupling are parameters of the equivalent circuit of the device (5) with the rotary magnetic coupling, a space vector of the field current calculated from measured phase field currents (3) using the Clark transformation (18) and measured rotor angular position (10) or rotor speed of the synchronous machine (1) multiplied by the number of pole pairs (17) of the device (5) with the rotary magnetic coupling, and the electric position or electric speed of the rotor of the device (5) with the rotary magnetic coupling is computed,
the mathematical model is used to calculate the space vector of the rotor voltage in the rotor reference frame as a sum of the time derivative of the space vector of the rotor flux of the device (5) with the rotary magnetic coupling and voltage drop across a rotor resistor, an electric angle of the rotary rectifier (4) then equals to the position of the calculated space vector of the rotor voltage in the rotor reference frame,
wherein either a phase and/or specific power electronics device of the rotary rectifier (4) where the fault occurs is determined from the value of the electric angle of the rotary rectifier (4) deducted at the instant where an anomaly in the shape of the measured waveform of the phase field current (3) with respect to the fault-free state occurs.

## Patentansprüche

1. Verfahren zur Fehlererkennung eines rotierenden Gleichrichters (4) von bürstenlosen Synchronmaschinen (6) mit Erregern vom Induktionsmotortyp, wobei der rotierende Gleichrichter (4) die Erregerfeldwicklung auf dem Rotor einer Synchronmaschine (1) mit einer Einrichtung (5) mit rotierender magnetischer Kupplung verbindet, die mit einer Wechselstrom-Erregerquelle (7) verbunden ist, **dadurch gekennzeichnet, dass** ein phasenbezogener Erregerstrom (3) an der Ausgangsseite der Wechselstrom-Erregerquelle (7) gemessen wird, die mit der Einrichtung (5) mit der rotierenden magnetischen Kupplung verbunden ist, dass ferner eine Frequenzanalyse (12) des gemessenen Erregerstroms (3)
die Amplitude seiner Grundschwingung mit derselben Frequenz wie das Netz, an das die bürstenlose Synchronmaschine (6) angeschlossen ist, und
die Amplituden aller ungleich Null ganzzahligen Vielfachen der Grundschwingungsfrequenz bis zur Summe aus der Netzfrequenz und dem Wert, der sich aus dem Produkt der Frequenz der Wechselstromversorgungsspannung des diagnostizierten rotierenden Gleichrichters (4) und seiner Pulszahl p ergibt, bestimmt,
wobei ferner aus einem Quotienten der Per-Unit-Fehlerfaktor *Xᵢ* berechnet wird, wobei
der Zähler eine Summe von Amplitudenwerten der bestimmten Frequenzkomponenten des gemessenen phasenbezogenen Erregerstroms (3) der Erregerquelle (2) mit Frequenzen größer als die Grundschwingungskomponente ist, jedoch unter Ausschluss zweier Frequenzkomponenten mit derart definierten Frequenzen, dass
die Frequenz der ersten ausgeschlossenen Frequenzkomponente dem Produkt aus der Frequenz der Wechselstromversorgungsspannung des diagnostizierten rotierenden Gleichrichters (4) und seiner Pulszahl *p* entspricht, erhöht um die Frequenz des Netzes, an das die bürstenlose Synchronmaschine (6) angeschlossen ist, und
die Frequenz der zweiten ausgeschlossenen Frequenzkomponente dem Produkt aus der Frequenz der Wechselstromversorgungsspannung des diagnostizierten rotierenden Gleichrichters (4) und seiner Pulszahl p entspricht, vermindert um die Frequenz des Netzes, an das die bürstenlose Synchronmaschine (6) angeschlossen ist,
und der Nenner eine Summe von Amplitudenwerten dieser beiden ausgeschlossenen Frequenzkomponenten des phasenbezogenen Erregerstroms (3) darstellt, der in einen Stator der Einrichtung (5) mit der rotierenden magnetischen Kupplung eintritt,
unter fehlerfreien Bedingungen ein fehlerfreier Referenz-Per-Unit-Faktor *X_{i_ref}* berechnet wird, anschließend wenigstens ein leistungselektronisches Bauelement des rotierenden Gleichrichters (4) elektrisch abgeschaltet wird und der Fehler-Referenz-Per-Unit-Faktor *X_{i_err}* bestimmt wird,
aus dem arithmetischen Mittel der Werte des fehlerfreien Referenz-Per-Unit-Faktors *X_{i_ref}* und des Fehler-Referenz-Per-Unit-Faktors *X_{i_err}* ein Per-Unit-Fehlererkennungsschwellenwert *X_{i_threshold}* berechnet wird,
und während des Betriebs des rotierenden Gleichrichters (4) der Per-Unit-Fehlerfaktor *Xᵢ* fortlaufend berechnet wird und nach Abschluss des Erregungsverfahrens der Synchronmaschine (1), das durch ein Signal (21) angezeigt wird, ein Fehler der Erregerquelle (2) signalisiert wird, falls
- der Per-Unit-Fehlerfaktor *Xᵢ* länger als über eine Periode der Grundschwingungsfrequenz größer als der Per-Unit-Fehlererkennungsschwellenwert *X_{i_threshold}* ist und/oder
- der Effektivwert des gemessenen phasenbezogenen Erregerstroms (3) außerhalb des zulässigen Betriebsbereichs liegt und/oder
- der Effektivwert der Gegen-EMK der Synchronmaschine (1) bei einem Erregerstrom (3), dessen Wert innerhalb des für die Synchronmaschine (1) definierten zulässigen Betriebsbereichs liegt, kleiner ist als der Effektivwert der Gegen-EMK der Synchronmaschine (1), der für den minimal zulässigen Betriebs-Erregerstrom (3) bestimmt ist, wobei die Gegen-EMK der Synchronmaschine (1) aus der gemessenen Klemmenspannung (9) bestimmt wird.

2. Verfahren nach Anspruch 1, **dadurch gekennzeichnet, dass** zusätzlich der Fehlertyp der Erregerquelle (2), der durch Kurzschluss oder Öffnen eines oder mehrerer leistungselektronischer Bauelemente des rotierenden Gleichrichters (4) verursacht ist, bestimmt wird, wenn die Größe des Effektivwerts des phasenbezogenen Erregerstroms (3) und der Effektivwert der Gegen-EMK der Synchronmaschine (1) im zulässigen Betriebsbereich liegen, durch Vergleich des fortlaufend bestimmten Per-Unit-Fehlerfaktors *Xᵢ* mit den im Voraus berechneten oder experimentell bestimmten Werten, die in einem Steuerrechner (8) für jeden Fehlertyp des rotierenden Gleichrichters (4) gespeichert sind.

3. Verfahren nach Anspruch 1 oder 2, **dadurch gekennzeichnet, dass** bei der Berechnung (13) des Per-Unit-Fehlerfaktors *Xᵢ* in der Summe im Zähler mindestens eine Oberschwingungsfrequenz ausgelassen wird.

4. Verfahren nach einem der vorangehenden Ansprüche 1 bis 3, **dadurch gekennzeichnet, dass** die Eingangsgrößen eines dynamischen mathematischen Modells der Einrichtung (5) mit der rotierenden magnetischen Kupplung Parameter der Ersatzschaltung der Einrichtung (5) mit der rotierenden magnetischen Kupplung, ein aus gemessenen phasenbezogenen Erregerströmen (3) unter Verwendung der Clarke-Transformation (18) berechneter Raumzeiger des Erregerstroms und eine gemessene Rotorwinkelposition (10) oder eine Rotordrehzahl der Synchronmaschine (1), multipliziert mit der Polpaarzahl (17) der Einrichtung (5) mit der rotierenden magnetischen Kupplung, sind und die elektrische Position oder elektrische Drehzahl des Rotors der Einrichtung (5) mit der rotierenden magnetischen Kupplung berechnet wird,
wobei das mathematische Modell dazu verwendet wird, den Raumzeiger der Rotorspannung im Rotorbezugskoordinatensystem als Summe aus der Zeitableitung des Raumzeigers des Rotorflusses der Einrichtung (5) mit der rotierenden magnetischen Kupplung und dem Spannungsabfall an einem Rotorwiderstand zu berechnen, wobei ein elektrischer Winkel des rotierenden Gleichrichters (4) dann der Lage des berechneten Raumzeigers der Rotorspannung im Rotorbezugskoordinatensystem entspricht,
wobei aus dem Wert des elektrischen Winkels des rotierenden Gleichrichters (4), der zu dem Zeitpunkt ermittelt wird, zu dem eine Anomalie in der Form des gemessenen Zeitverlaufs des phasenbezogenen Erregerstroms (3) gegenüber dem fehlerfreien Zustand auftritt, ermittelt wird, in welcher Phase und/oder in welchem spezifischen leistungselektronischen Bauelement des rotierenden Gleichrichters (4) der Fehler auftritt.

## Revendications

1. Procédé de détection de défaut d'un redresseur rotatif (4) de machines synchrones sans balais (6) ayant des excitateurs de type moteur à induction, le redresseur rotatif (4) reliant l'enroulement de champ d'excitation sur le rotor d'une machine synchrone (1) à un dispositif (5) avec couplage magnétique rotatif, qui est relié à une source d'excitation en courant alternatif (7), le procédé étant **caractérisé en ce qu'**un courant de champ de phase (3) est mesuré du côté de sortie de la source d'excitation en courant alternatif (7) qui est reliée au dispositif (5) avec le couplage magnétique rotatif, qu'en outre une analyse fréquentielle (12) du courant de champ mesuré (3) détermine
l'amplitude de son harmonique fondamental ayant la même fréquence que le réseau électrique auquel est reliée la machine synchrone sans balais (6), et
les amplitudes de tous les multiples entiers non nuls de la fréquence de l'harmonique fondamental jusqu'à la somme de la fréquence du réseau électrique et de la valeur résultant du produit de la fréquence de la tension d'alimentation en courant alternatif du redresseur rotatif diagnostiqué (4) et de son nombre d'impulsions p,
en outre, un quotient est utilisé pour calculer un facteur de défaut en unités relatives *Xᵢ,* dans lequel
le numérateur est une somme de valeurs des amplitudes des composantes fréquentielles déterminées du courant de champ de phase mesuré (3) de la source d'excitation (2) ayant des fréquences supérieures à la composante harmonique fondamentale, sous réserve toutefois de l'exclusion de deux composantes fréquentielles dont les fréquences sont définies de telle sorte que
la fréquence de la première composante fréquentielle exclue est égale au produit de la fréquence de la tension d'alimentation en courant alternatif du redresseur rotatif diagnostiqué (4) et de son nombre d'impulsions *p,* augmenté de la fréquence du réseau électrique auquel est reliée la machine synchrone sans balais (6), et
la fréquence de la seconde composante fréquentielle exclue est égale au produit de la fréquence de la tension d'alimentation en courant alternatif du redresseur rotatif diagnostiqué (4) et de son nombre d'impulsions *p*, diminué de la fréquence du réseau électrique auquel est reliée la machine synchrone sans balais (6),
et le dénominateur est une somme de valeurs des amplitudes provenant desdites deux composantes fréquentielles exclues du courant de champ de phase (3) entrant dans un stator du dispositif (5) avec le couplage magnétique rotatif,
dans un état exempt de défaut, un facteur de référence en unités relatives sans défaut *X_{i_ref}* est calculé, suivi d'une déconnexion électrique d'au moins un élément d'électronique de puissance du redresseur rotatif (4), et un facteur de référence en unités relatives de défaut *X_{i_err}* est déterminé,
la moyenne arithmétique des valeurs du facteur de référence en unités relatives sans défaut *X_{i_ref}* et du facteur de référence en unités relatives de défaut *X_{i_err}* est utilisée pour calculer un seuil de détection de défaut en unités relatives *X_{i_threshold}*,
et pendant le fonctionnement du redresseur rotatif (4), le facteur de défaut en unités relatives *Xᵢ* est calculé en continu et, une fois la procédure d'excitation de la machine synchrone (1) terminée, ce qui est indiqué par un signal (21), un défaut de la source d'excitation (2) est signalé si
- le facteur de défaut en unités relatives *Xᵢ* est supérieur au seuil de détection de défaut en unités relatives *X_{i_threshold}* pendant une durée supérieure à une période de la fréquence de l'harmonique fondamental et/ou
- la valeur efficace du courant de champ de phase mesuré (3) est en dehors de la plage de fonctionnement admise et/ou
- la valeur efficace de la force électromotrice inverse de la machine synchrone (1), pour un courant de champ de phase (3) dont la valeur est dans la plage de fonctionnement admissible définie pour la machine synchrone (1), est inférieure à la valeur efficace de la force électromotrice inverse de la machine synchrone (1) déterminée pour le courant de champ de phase (3) minimal admissible en fonctionnement, la force électromotrice inverse de la machine synchrone (1) étant déterminée à partir de la tension aux bornes mesurée (9).

2. Procédé selon la revendication 1, **caractérisé en ce qu'**en outre le type de défaut de la source d'excitation (2) provoqué par un court-circuit ou une ouverture d'un ou de plusieurs éléments d'électronique de puissance du redresseur rotatif (4) est déterminé, lorsque la valeur efficace du courant de champ de phase (3) et la valeur efficace de la force électromotrice inverse de la machine synchrone (1) se situent dans la plage de fonctionnement admise, par comparaison du facteur de défaut en unités relatives *Xᵢ* déterminé en continu avec les valeurs calculées à l'avance ou déterminées expérimentalement, qui sont stockées dans un ordinateur de commande (8) pour chaque type de défaut du redresseur rotatif (4).

3. Procédé selon la revendication 1 ou 2, **caractérisé en ce qu'**au moins une fréquence harmonique est omise dans le calcul (13) du facteur de défaut en unités relatives *Xᵢ* dans la somme au numérateur.

4. Procédé selon l'une quelconque des revendications précédentes 1 à 3, **caractérisé en ce que** les grandeurs d'entrée d'un modèle mathématique dynamique du dispositif (5) avec le couplage magnétique rotatif sont des paramètres du schéma équivalent du dispositif (5) avec le couplage magnétique rotatif, un vecteur spatial du courant de champ calculé à partir des courants de champ de phase mesurés (3) à l'aide de la transformation de Clarke (18) et une position angulaire de rotor mesurée (10) ou une vitesse de rotor de la machine synchrone (1) multipliée par le nombre de paires de pôles (17) du dispositif (5) avec le couplage magnétique rotatif, et la position électrique ou la vitesse électrique du rotor du dispositif (5) avec le couplage magnétique rotatif est calculée,
le modèle mathématique étant utilisé pour calculer le vecteur spatial de la tension de rotor dans le repère de référence du rotor comme la somme de la dérivée temporelle du vecteur spatial du flux de rotor du dispositif (5) avec le couplage magnétique rotatif et de la chute de tension sur une résistance de rotor, un angle électrique du redresseur rotatif (4) étant alors égal à la position du vecteur spatial calculé de la tension de rotor dans le repère de référence du rotor,
et la phase et/ou l'élément spécifique d'électronique de puissance du redresseur rotatif (4) dans lequel le défaut se produit sont déterminés à partir de la valeur de l'angle électrique du redresseur rotatif (4) relevée à l'instant où une anomalie dans la forme de l'onde mesurée du courant de champ de phase (3) par rapport à l'état exempt de défaut se produit.
